# EUROPÄISCHE PATENTSCHRIFT

(11) **EP 3 921 662 B1**
(45) Veröffentlichungstag und Bekanntmachung des Hinweises auf die Patenterteilung: **06.09.2023**
(21) Anmeldenummer: 19703718.7
(22) Anmeldetag: 06.02.2019
(51) Int. Cl.: G01R 33/02

(54) **MAGNETFELD-SENSORVORRICHTUNG**
MAGNETIC-FIELD SENSOR DEVICE
DISPOSITIF DE CAPTEUR DE CHAMP MAGNÉTIQUE

(43) Veröffentlichungstag der Anmeldung: 15.12.2021
(73) Patentinhaber: Fraba B.V., 6416 SG Heerlen (NL)
(72) Erfinder: LÖKEN, Michael, 52428 Jülich (DE)
(74) Vertreter: terpatent Patentanwälte ter Smitten Eberlein-Van Hoof Rütten Daubert
(86) Internationale Anmeldenummer: PCT/EP2019/052908
(87) Internationale Veröffentlichungsnummer: WO 2020/160766

(56) Entgegenhaltungen:
- DE-A1-102012 008 888
- DE-B3-102004 013 022
- US-A- 6 084 400

## Beschreibung

Die Erfindung betrifft eine Magnetfeld-Sensorvorrichtung mit mindestens zwei Impulsdrähten, einer Spulenanordnung, die die mindestens zwei Impulsdrähte radial umschließt, wobei die Spulenanordnung ein Sensorelement und ein Rückkopplungselement, durch das ein Hilfsmagnetfeld erzeugbar ist, bildet, einem Energiespeicher, der elektrisch mit der Spulenanordnung verbunden ist, und einem Schaltelement, das elektrisch mit dem Energiespeicher und dem Rückkopplungselement verbunden ist.

Magnetfeld-Sensorvorrichtungen werden beispielsweise in Drehwinkelmesssystemen verwendet um die Drehbewegung einer Welle zu erfassen. Typischerweise ist mindestens ein Permanentmagnet an der Welle befestigt, dessen Magnetfeld von der Magnetfeld-Sensorvorrichtung erfasst wird. Hierfür weist die Magnetfeld-Sensorvorrichtung mindestens einen magnetisch bistabilen Impulsdraht - auch als Wiegand-Draht bezeichnet - auf, dessen Magnetisierungsrichtung unter Einwirkung eines externen Magnetfelds schlagartig umklappt, sobald eine spezifische Auslösefeldstärke überschritten wird. Hierdurch wird in einer Sensorspule, die den Impulsdraht radial umschließt und ein Sensorelement einer Spulenanordnung bildet, ein kurzer Spannungspuls erzeugt, der von einer Folgeelektronik ausgewertet werden kann. Die elektrische Energie des erzeugten Spannungspulses kann hierbei - zumindest teilweise - zur Energieversorgung der Magnetfeld-Sensorvorrichtung verwendet werden. Das Umklappen der Magnetisierungsrichtung eines Impulsdrahts wird nachfolgend auch als "Auslösen" des Impulsdrahts bezeichnet.

Aus der DE 199 25 884 C2 ist eine Magnetfeld-Sensorvorrichtung bekannt, die mehrere Impulsdrähte aufweist. Hierbei wird durch die mehreren Impulsdrähte genügend elektrische Energie in der Spulenanordnung erzeugt, um einen energie-autarken Betrieb der Magnetfeld-Sensorvorrichtung zu ermöglichen. Für die Magnetfeld-Sensorvorrichtung muss folglich keine externe Energieversorgung vorgesehen werden. DE102004013022 und DE102012008888 offenbaren Magnetfeld Sensorvorrichtungen mit Impulsdrähten.

Herstellungsbedingt können die mehreren Impulsdrähte verschiedene Auslösefeldstärken aufweisen, sodass die Impulsdrähte bei unterschiedlichen lokalen Feldstärken des externen Magnetfelds und somit bei geringfügig unterschiedlichen Drehwinkelpositionen der Welle auslösen. Hierdurch kann es dazu kommen, dass bei einer definierten Drehwinkelposition der Welle mindestens ein erster Impulsdraht auslöst, während mindestens ein zweiter Impulsdraht nicht auslöst. Dies kann zum einen die Messergebnisse der Magnetfeld-Sensorvorrichtung verfälschen, und zum anderen kann dies auch dazu führen, dass bei einer Magnetfeld-Sensorvorrichtung ohne externe Energieversorgung nicht genügend elektrische Energie für einen ordnungsgemäßen Betrieb einer Folgeelektronik erzeugt wird.

Um sicherzustellen, dass alle Impulsdrähte auslösen, sobald die Auslöseschwelle mindestens eines Impulsdrahts überschritten ist, weist die offenbarte Magnetfeld-Sensorvorrichtung einen Energiespeicher, eine Spulenanordnung mit einem Rückkopplungselement, und ein Schaltelement auf. Die Spulenanordnung kann hierbei eine separate Rückkopplungsspule aufweisen, die das Rückkopplungselement bildet, oder das Rückkopplungselement kann durch die Sensorspule gebildet sein. Die durch einen ersten Impulsdraht, der eine relativ geringe Auslöseschwelle aufweist, in dem Sensorelement der Spulenanordnung erzeugte elektrische Energie wird in dem Energiespeicher zwischengespeichert. Die gespeicherte Energie wird anschließend dazu verwendet in dem Rückkopplungselement der Spulenanordnung ein Hilfsmagnetfeld zu erzeugen, das zeitgleich mit dem externen Magnetfeld auftritt und zu dem externen Magnetfeld gleichgerichtet ist. Das Gesamtmagnetfeld - also die Summe aus externem Magnetfeld und Hilfsmagnetfeld - überschreitet hierbei die Auslösefeldstärke aller übrigen Impulsdrähte. Hierdurch ist sichergestellt, dass sobald die Auslöseschwelle mindestens eines Impulsdrahts überschritten ist, alle Impulsdrähte der Magnetfeld-Sensorvorrichtung auslösen.

Gemäß der Beschreibung der DE 199 25 884 C2 ist das Schaltelement vorzugsweise ein einfacher Kondensator, der einerseits ein kontinuierliches Entladen des Energiespeichers über das Rückkopplungselement der Spulenanordnung verhindert, und andererseits - bei dem Auftreten eines Spannungspulses in dem Sensorelement der Spulenanordnung - ein pulsartiges Entladen des Energiespeichers über das Rückkopplungselement der Spulenanordnung ermöglicht. Bei einem derartigen Aufbau der Magnetfeld-Sensorvorrichtung erfolgt bei jedem Auslösen des ersten Impulsdrahtes eine Entladung des Energiespeicher über das Rückkopplungselement der Spulenanordnung und folglich eine Hilfsmagnetfeld-Erzeugung. Dies geschieht unabhängig davon, ob die übrigen Impulsdrähte durch das externe Magnetfeld bereits ausgelöst wurden oder nicht. In dem Fall, dass durch das externe Magnetfeld bereits alle Impulsdrähte ausgelöst wurden, wird folglich unnötigerweise elektrische Energie in der Rückkopplungsspule verbraucht, die daher nicht mehr für die Energieversorgung der Magnetfeld-Sensorvorrichtung zur Verfügung steht.

Es stellt sich daher die Aufgabe, eine Magnetfeld-Sensorvorrichtung zu schaffen, die ohne externe Energieversorgung auskommt und besonders energieeffizient arbeitet.

Diese Aufgabe wird durch eine Magnetfeld-Sensorvorrichtung mit den Merkmalen des Hauptanspruchs 1 gelöst.

Erfindungsgemäß ist eine Steuereinheit zur elektrischen Ansteuerung des Schaltelements vorgesehen ist. Die Steuereinheit ermöglicht eine gezielte Steuerung des Schaltzustands des Schaltelements und somit eine gezielte und bedarfsweise Hilfsmagnetfeld-Erzeugung. Die Steuereinheit kann als separate Baugruppe vorgesehen sein, kann alternativ jedoch auch in ein Elektronikbaugruppe der Magnetfeld-Sensorvorrichtung integriert sein. Beispielsweise kann die Magnetfeld-Sensorvorrichtung einen digitalen Schaltkreis - wie einen Mikrokontroller oder ein sogenanntes Field Programmable Gate Array (FPGA) - aufweisen, der sowohl eine Auswerteeinheit zur Ermittlung eines Drehwinkels als auch die Steuereinheit bildet. Hierbei ist durchaus denkbar, dass die Steuereinheit als ein in den digitalen Schaltkreis einprogrammierter Algorithmus beziehungsweise Programm realisiert ist.

Die Steuereinheit ermöglicht beispielsweise eine gezielte Hilfsmagnetfeld-Erzeugung in Abhängigkeit von einer in dem Sensorelement der Spulenanordnung durch die Impulsdrähte erzeugten elektrischen Gesamtenergie. Hierbei findet die Hilfsmagnetfeld-Erzeugung nur dann statt, wenn die in der Spulenanordnung erzeugte elektrische Energie einen bestimmten Mindest-Energiewert unterschreitet. Der Mindest-Energiewert kann hierbei entweder ein fest vordefinierter Wert sein, oder kann alternativ ein variabler Wert sein, der an den aktuellen Energiebedarf der Magnetfeld-Sensorvorrichtung anpassbar ist. In beiden Fällen ist auf Grund der gezielten Ansteuerung des Schaltelements durch die Steuereinheit sichergestellt, dass die Hilfsmagnetfeld-Erzeugung nur dann stattfindet, wenn das externe Magnetfeld nicht ausreicht um alle Impulsdrähte auszulösen. Hierdurch ist der für die Hilfsmagnetfeld-Erzeugung benötigte Energieaufwand minimal, sodass die in der Spulenanordnung durch das Auslösen der Impulsdrähte erzeugte elektrische Energie zu einem Großteil für die Energieversorgung der Magnetfeld-Sensorvorrichtung zur Verfügung steht.

Ferner ermöglicht die Steuereinheit auch eine Anpassung des Zeitpunkts der Hilfsmagnetfeld-Erzeugung zur Synchronisation mit dem zeitlichen Verlauf des externen Magnetfelds. Beispielsweise kann das Hilfsmagnetfeld gezielt zu dem Zeitpunkt erzeugt werden, an dem das externe Magnetfeld maximal ist, sodass ein relativ geringes Hilfsmagnetfeld ausreicht um alle Impulsdrähte auszulösen. Insbesondere ermöglicht die Steuereinheit hierbei auch eine kontinuierliche Anpassung des Hilfsmagnetfeld-Erzeugungszeitpunkts, beispielsweise in Abhängigkeit einer aktuellen Wellen-Drehzahl.

Durch die erfindungsgemäße Steuereinheit ist die für die Hilfsmagnetfeld-Erzeugung benötigte elektrische Energie minimal und ist folglich der für die Energieversorgung nutzbare Anteil der in den Impulsdrähten erzeugten elektrischen Energie maximal. Die erfindungsgemäße Magnetfeld-Sensorvorrichtung kommt daher ohne externe Energieversorgung aus und arbeitet besonders energieeffizient.

In einer bevorzugten Ausführung der Erfindung weist die Steuereinheit ein Verzögerungsmodul auf. Das Verzögerungsmodul ist direkt oder indirekt mit der Spulenanordnung verbunden, sodass das Verzögerungsmodul durch einen Spannungspuls in dem Sensorelement der Spulenanordnung ansteuerbar ist. Das Verzögerungsmodul ist derart ausgelegt, dass es nach einer vorbestimmten Verzögerungszeit ein Trigger-Signal bereitstellt, wenn es durch einen Spannungspuls in dem Sensorelement der Spulenanordnung angesteuert wird. Das Verzögerungsmodul ermöglicht eine gezielte Auslegung und/oder Anpassung des Zeitpunkts an dem das Schaltelement zur Erzeugung des Hilfsmagnetfelds angesteuert wird. Das Verzögerungsmodul kann vollständig aus einfachen und kostengünstigen analogen Bauelementen - wie Widerstände, Kondensatoren und/oder Spulen - aufgebaut sein, wobei die Verzögerungszeit von den Eigenschaften der verwendeten Bauelemente und deren elektrischer Verschaltung abhängt. Alternativ kann das Verzögerungsmodul auch durch einen digitalen Schaltkreis - beispielsweise durch einen Mikrocontroller oder ein FPGA - gebildet sein, wobei die Verzögerungszeit vorzugsweise elektronisch einstellbar ist.

Vorteilhafterweise weist die Steuereinheit ein Ladezustands-Erfassungsmodul auf, durch das ein aktueller Ladezustand des Energiespeichers erfassbar ist. Hierbei muss das Ladezustands-Erfassungsmodul für die Ladezustandserfassung nicht zwangsläufig direkt elektrisch mit dem Energiespeicher verbunden sein. Beispielsweise kann das Ladezustands-Erfassungsmodul auch einen elektrischen Kennwert erfassen, der direkt proportional zu dem Ladezustand des Energiespeichers ist. Der Energiespeicher-Ladezustand ist beispielsweise auf einfache Weise durch eine Auswertung der an dem Energiespeicher anliegenden elektrischen Spannung erfassbar. Die Steuereinheit ist ferner ausgelegt, das Schaltelement in Abhängigkeit des von dem Ladezustands-Erfassungsmodul erfassten Energiespeicher-Ladezustands zu steuern. Da der Energiespeicher-Ladezustand zum einen von der in den Impulsdrähten erzeugten elektrischen Energie und zum anderen vom Energieverbrauch der Magnetfeld-Sensorvorrichtung abhängt, ermöglicht die Steuerung des Schaltelements in Abhängigkeit des Ladezustands eine besonders effiziente Steuerung der Hilfsmagnetfeld-Erzeugung und somit eine besonders energieeffiziente Magnetfeld-Sensorvorrichtung.

Auf Grund von herstellungsbedingten Variationen der Eigenschaften der Impulsdrähte kann es zu einer zeitlichen Verzögerung zwischen den Auslösezeitpunkten der einzelnen Impulsdrähte kommen. In einer besonders vorteilhaften Ausführung der Erfindung ist daher die Steuereinheit ausgelegt, als Reaktion auf das Trigger-Signal des Verzögerungsmoduls eine Ladezustandserfassung durch das Ladezustands-Erfassungsmodul auszulösen. Die Ladezustandserfassung findet somit definiert zeitlich verzögert zum Auslösezeitpunkt des ersten Impulsdrahts statt. Durch die verzögerte Ladezustandserfassung wird vor der Erzeugung des Hilfsmagnetfelds sichergestellt, dass die übrigen Impulsdrähte nicht doch noch durch das externe Magnetfeld ausgelöst wurden. Hierdurch wird eine unnötige Hilfsmagnetfeld-Erzeugung besonders zuverlässig verhindert und folglich eine energieeffiziente Magnetfeld-Sensorvorrichtung geschaffen.

Besonders bevorzugt ist die Steuereinheit ausgelegt, bei einem erfassten Ladezustand unterhalb eines Ladezustands-Schwellenwert das Schaltelement zur Erzeugung des Hilfsmagnetfelds anzusteuern. Der Ladezustands-Schwellenwert ist hierbei vorzugsweise derart ausgelegt, dass ab dem Ladezustands-Schwellenwert die im Energiespeicher gespeicherte elektrische ausreicht um einen zuverlässigen Betrieb der Magnetfeld-Sensorvorrichtung sicherzustellen. Bei dieser Auslegung wird das Hilfsmagnetfeld - unabhängig davon, ob alle Impulsdrähte ausgelöst haben oder nicht - nur dann erzeugt, wenn die im Energiespeicher gespeicherte Energie zu gering ist um die Energieversorgung der Magnetfeld-Sensorvorrichtung sicherzustellen. Um sicherzustellen, dass immer alle Impulsdrähte auslösen kann der Ladezustands-Schwellenwert alternativ auch derart ausgelegt sein, dass er unterschritten wird, sobald nicht alle Impulsdrähte auslösen. Hierdurch wird ein Sensorsignal mit einer relativ konstanten Amplitude erzeugt, wodurch eine besonders einfache und zuverlässige Bestimmung des Drehwinkels ermöglicht wird.

Vorteilhafterweise weist die Spulenanordnung eine einzige Spule auf, die die Impulsdrähte radial umgibt und die sowohl das Sensorelement als auch das Rückkopplungselement bildet. Dies ermöglicht eine besonders kompakte und kostengünstige Magnetfeld-Sensorvorrichtung. Ferner wird bei diesem Aufbau - im Vergleich zu einer Spulenanordnung mit einer Sensorspule und einer separaten Rückkopplungsspule - beim Auslösen der Impulsdrähte eine höhere elektrische Spannung und somit mehr elektrische Energie in dem Sensorelement der Spulenanordnung erzeugt.

In einer bevorzugten Ausführung der Erfindung ist der Energiespeicher ein einfacher und kostengünstiger Kondensator.

Vorzugsweise ist das Schaltelement ein Halbleiterschalter, der kostengünstig ist und gleichzeitig auf einfache Weise elektrisch durch die Steuereinheit ansteuerbar ist.

Zwei Ausführungsbeispiele einer erfindungsgemäßen Magnetfeld-Sensorvorrichtung werden nachfolgend anhand der beigefügten Figuren beschrieben, wobei
Figur 1 eine schematische Darstellung eines ersten Ausführungsbeispiels einer erfindungsgemäßen Magnetfeld-Sensorvorrichtung zeigt, wobei die Spulenanordnung eine Sensorspule und eine separate Rückkopplungsspule aufweist, und
Figur 2 eine schematische Darstellung eines zweiten Ausführungsbeispiels einer erfindungsgemäßen Magnetfeld-Sensorvorrichtung zeigt, wobei die Spulenanordnung eine einzige Spule aufweist, die sowohl das Sensorelement als auch das Rückkopplungselement bildet.

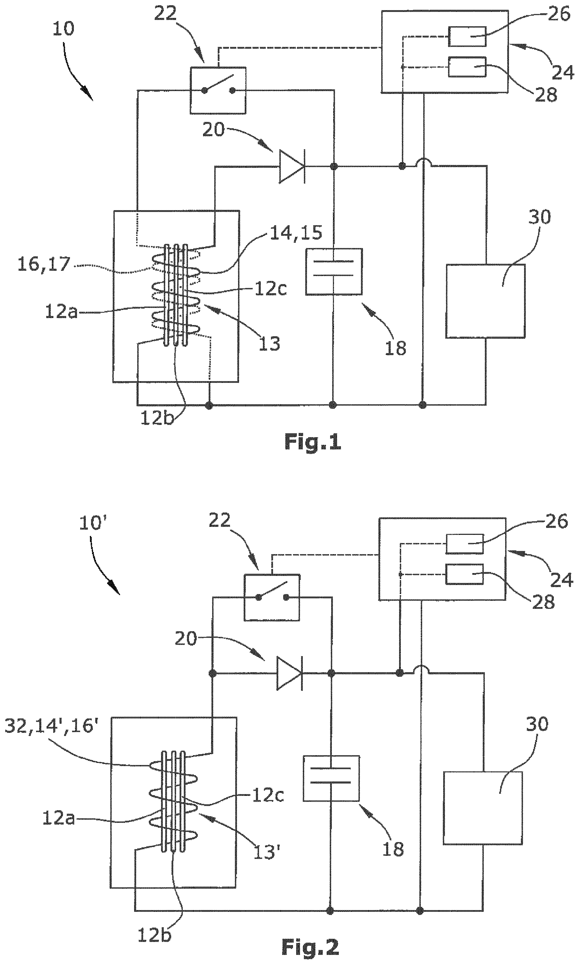

Figur 1 zeigt eine Magnetfeld-Sensorvorrichtung 10 mit drei Impulsdrähten 12a-c, die von einer Spulenanordnung 13 radial umschlossen sind. Die Spulenanordnung 13 umfasst eine Sensorspule 15, die ein Sensorelement 14 bildet, und umfasst eine separate Rückkopplungsspule 17 die ein Rückkopplungselement 16 bildet. Die Rückkopplungsspule 17 weist hierbei die gleiche Wicklungsrichtung wie die Sensorspule 15 auf. Die drei Impulsdrähte 12a-c erstrecken sich im Wesentlichen parallel zueinander. Die drei Impulsdrähte 12a-c bestehen aus einem magnetisch bistabilen Material, dessen Magnetisierungsrichtung unter Einwirkung eines externen Magnetfelds schlagartig umklappt, sobald das externe Magnetfeld eine spezifische Auslösefeldstärke überschreitet. Derartige Impulsdrähte werden auch als Wiegand-Drähte bezeichnet. Hierbei wird durch das Umklappen der Magnetisierungsrichtung pro Impulsdraht 12a-c jeweils ein elektrischer Spannungspuls in dem Sensorelement 14 induziert.

Durch elektrische Bestromung des Rückkopplungselements 16 ist ein auf die Impulsdrähte 12a-c einwirkendes Hilfsmagnetfeld erzeugbar. Hierbei ist das Hilfsmagnetfeld dem externen Magnetfeld gleichgerichtet, sodass bei Bestromung des Rückkopplungselements 16 auf die Impulsdrähte 12a-c ein Gesamtmagnetfeld einwirkt, dass stärker ist als das externe Magnetfeld.

Die Magnetfeld-Sensorvorrichtung 10 umfasst ferner einen Energiespeicher 18, der im vorliegenden Ausführungsbeispiel durch einen einfachen Kondensator gebildet ist. Ein erster Anschluss des Energiespeichers 18 ist mit einem ersten Ende des Sensorelements 14 elektrisch verbunden, und ein zweiter Anschluss des Energiespeichers 18 ist über eine Diode 20 mit einem zweiten Ende des Sensorelements 14 elektrisch verbunden. Die Diode 20 ist hierbei derart angeordnet, dass ein Stromfluss von dem zweiten Ende des Sensorelements 14 in Richtung des zweiten Anschlusses des Energiespeichers 18 möglich ist, ein umgekehrter Stromfluss von dem zweiten Anschluss des Energiespeichers 18 in Richtung des zweiten Endes des Sensorelements 14 jedoch blockiert ist. Die Diode 20 ermöglich somit ein Aufladen des Energiespeichers 18 durch die in dem Sensorelement 14 von den Impulsdrähten 12a-c erzeugten Spannungspulse, verhindert jedoch ein Entladen des Energiespeichers 18 über das Sensorelement 14, wenn das Sensorelement 14 spannungsfrei ist.

Die Magnetfeld-Sensorvorrichtung 10 umfasst ferner ein elektrisch steuerbares Schaltelement 22 und eine Steuereinheit 24 zur elektrischen Ansteuerung des Schaltelements 22. Das Schaltelement 22 ist im vorliegenden Ausführungsbeispiel ein Halbleiterschalter, beispielsweise ein Bipolartransistor oder ein Feldeffekttransistor. Ein erster Anschluss des Schaltelements 22 ist mit dem zweiten Anschluss des Energiespeichers 18 elektrisch verbunden, und ein zweiter Anschluss des Schaltelements 22 ist mit einem ersten Ende des Rückkopplungselements 16 elektrisch verbunden. Das zweite Ende des Rückkopplungselements 16 ist mit dem ersten Ende des Energiespeichers 18 elektrisch verbunden. Ein Steueranschluss des Schaltelements 22 - über den der Schaltzustand des Schaltelements 22 und somit der Stromfluss durch das Schaltelement 22 elektrisch steuerbar ist - ist mit der Steuereinheit 24 verbunden. Über den Steueranschluss des Schaltelements 22 ist folglich die elektrische Bestromung des Rückkopplungselements 16 und somit die Hilfsmagnetfeld-Erzeugung durch die Steuereinheit 24 elektrisch steuerbar.

Die Steuereinheit 24 umfasst ein Verzögerungsmodul 26, das direkt oder indirekt mit dem Sensorelement 14 verbunden ist, sodass das Verzögerungsmodul 26 durch einen Spannungspuls in dem Sensorelement 14 ansteuerbar ist. Das Verzögerungsmodul 26 ist derart ausgelegt, dass es nach einer definierten Verzögerungszeit ein Trigger-Signal an die Steuereinheit 24 bereitstellt. Das Trigger-Signal wird somit mit einer definierten zeitlichen Verzögerung zu dem Spannungspuls in dem Sensorelement 14 bereitgestellt. Die Verzögerungszeit des Verzögerungsmoduls 26 ist hierbei im vorliegenden Ausführungsbeispiel von der Steuereinheit 24 elektronisch einstellbar.

Die Steuereinheit 24 umfasst ferner ein Ladezustands-Erfassungsmodul 28, durch das ein aktueller Ladezustand des Energiespeichers 18 erfassbar ist. Hierbei detektiert das Ladezustands-Erfassungsmodul 28 im vorliegenden Ausführungsbeispiel eine elektrische Spannung, die gleich oder zumindest direkt proportional zu der elektrischen Spannung an dem Energiespeicher 18 ist, und ermittelt aus der detektierten Spannung den Energiespeicher-Ladezustand. Der erfasste Energiespeicher-Ladezustand wird der Steuereinheit 24 bereitgestellt.

Im vorliegenden Ausführungsbeispiel ist die Steuereinheit 24 derart ausgelegt, dass als Reaktion auf das Trigger-Signal der Verzögerungseinheit 26 eine Erfassung des Energiespeicher-Ladezustands durch das Ladezustands-Erfassungsmodul 28 ausgelöst wird. Der erfasste Energiespeicher-Ladezustand wird von der Steuereinheit 24 ausgewertet. Wenn der erfasste Energiespeicher-Ladezustand einen definierten Ladezustands-Schwellenwert unterschreitet, dann steuert die Steuereinheit 24 das Schaltelement 22 kurzzeitig an, um das Rückkopplungselement 16 kurzzeitig zu bestromen und dadurch das Hilfsmagnetfeld zu erzeugen. Der Ladezustands-Schwellenwert ist hierbei im vorliegenden Ausführungsbeispiel von der Steuereinheit 24 an eine von einer Folgeelektronik 30 der Magnetfeld-Sensorvorrichtung 10 bestimmte Wellen-Drehzahl adaptierbar.

Figur 2 zeigt eine alternative erfindungsgemäße Magnetfeld-Sensorvorrichtung 10'. Die Magnetfeld-Sensorvorrichtung 10' unterscheidet sich von der in Figur 1 dargestellten Magnetfeld-Sensorvorrichtung 10 im Wesentlichen dadurch, dass die Spulenanordnung 13' nur eine einzige Mehrzweck-Spule 32 aufweist, die sowohl das Sensorelement 14' als auch das Rückkopplungselement 16' bildet.

Ein erstes Ende der Mehrzweck-Spule 32 ist mit dem ersten Ende des Energiespeichers 18 verbunden. Ein zweites Ende der Mehrzweck-Spule 32 ist sowohl mit der Diode 20 als auch mit dem Schaltelement 22 elektrisch verbunden. Über die Diode 20 kann der Energiespeicher 18 durch den beim Auslösen der Impulsdrähte in der Mehrzweck-Spule 32 induzierten Spannungspuls geladen werden. Ferner kann die Mehrzweck-Spule 32 durch Ansteuern des Schaltelements 22 mit Hilfe der im Energiespeicher 18 gespeicherten elektrischen Energie bestromt werden, um das auf die Impulsdrähte 12a-c einwirkende Hilfsmagnetfeld zu erzeugen.

Es sollte deutlich sein, dass der Schutzbereich der vorliegenden Anmeldung nicht auf die beschriebenen Ausführungsbeispiele beschränkt ist. Insbesondere ist der Schutzbereich nicht auf die in den Ausführungsbeispielen dargestellte elektrische Verschaltung der Komponenten beschränkt. Ferner kann die erfindungsgemäße Magnetfeld-Sensorvorrichtung auch eine andere Anzahl von Impulsdrähten aufweisen. Es ist ebenfalls denkbar, dass die Steuereinheit und die Folgeelektronik durch einen einzigen elektrischen Schaltkreis gebildet sind.

### Bezugszeichenliste

- 10; 10': Magnetfeld-Sensorvorrichtung
- 12a-c: Impulsdrähte
- 13;13': Spulenanordnung
- 14;14': Sensorelement
- 15: Sensorspule
- 16;16': Rückkopplungselement
- 17: Rückkopplungsspule
- 18: Energiespeicher
- 20: Diode
- 22: Schaltelement
- 24: Steuereinheit
- 26: Verzögerungsmodul
- 28: Ladezustands-Erfassungsmodul
- 30: Folgeelektronik
- 32: Mehrzweck-Spule

## Patentansprüche

1. Magnetfeld-Sensorvorrichtung (10;10') mit
- mindestens zwei Impulsdrähten (12a-c),
- einer Spulenanordnung (13;13'), die die mindestens zwei Impulsdrähte (12a-c) radial umschließt, wobei die Spulenanordnung (13;13')
• ein Sensorelement (14; 14') und
• ein Rückkopplungselement (16;16'), durch das ein Hilfsmagnetfeld erzeugbar Ist, bildet,
- einem Energiespeicher (18), der elektrisch mit der Spulenanordnung (13;13') verbunden ist, und
- einem Schaltelement (22), das elektrisch mit dem Energiespeicher (18) und dem Rückkopplungselement (16;16') verbunden ist,
**dadurch gekennzeichnet, dass**
eine Steuereinheit (24) zur elektrischen Ansteuerung des Schaltelements (22) vorgesehen ist, wobei die Steuereinheit (24) ein Ladezustands-Erfassungsmodul (28) aufweist, durch das ein aktueller Ladezustand des Energiespeichers (18) erfassbar ist, und wobei die Steuereinheit (24) ausgelegt ist, das Schaltelement (22) in Abhängigkeit des von dem Ladezustands-Erfassungsmodul (28) erfassten Ladezustands zu steuern, und
wobei die Steuereinheit (24) ausgelegt ist,
bei einem erfassten Ladezustand unterhalb eines Ladezustands-Schwellenwert das Schaltelement (22) anzusteuern.

2. Magnetfeld-Sensorvorrichtung (10;10') nach Anspruch 1, wobei die Steuereinheit (24) ein Verzögerungsmodul (26) aufweist, das durch einen Spannungspuls in dem Sensorelement (14;14') der Spulenanordnung (13;13') ansteuerbar ist, und das ausgelegt ist, nach einer vorbestimmten Verzögerungszeit ein Trigger-Signal bereitzustellen.

3. Magnetfeld-Sensorvorrichtung (10;10`) nach Anspruch 2, wobei die Steuereinheit (24) ausgelegt ist, als Reaktion auf das Trigger-Signal des Verzögerungsmoduls (26) eine Ladezustandserfassung durch das Ladezustands-Erfassungsmodul (28) auszulösen.

4. Magnetfeld-Sensorvorrichtung (10') nach einem der vorhergehenden Ansprüche, wobei die Spulenanordnung (13`) eine einzige Spule (32) aufweist, die sowohl das Sensorelement (14') als auch das Rückkopplungselement (16') bildet.

5. Magnetfeld-Sensorvorrichtung (10;10') nach einem der vorhergehenden Ansprüche, wobei der Energiespeicher (18) ein Kondensator ist.

6. Magnetfeld-Sensorvorrichtung (10;10') nach einem der vorhergehenden Ansprüche, wobei das Schaltelement (22) ein Halbleiterschalter ist.

## Claims

1. Magnetic field sensor device (10;10') with
- at least two pulse wires (12a-c),
- a coil arrangement (13;13') which radially surrounds the at least two pulse wires (12a-c), the coil arrangement (13;13') comprising
• a sensor element (14;14') and
• a feedback element (16;16') by means of which an auxiliary magnetic field can be generated,
- an energy storage (18), which is electrically connected to the coil arrangement (13;13'), and
- a switching element (22) which is electrically connected to the energy storage (18) and to the feedback element (16;16'),
**characterized in that**
a control unit (24) for electrically driving the switching element (22) is provided, wherein the control unit (24) is provided with a state-of-charge detection module (28) by means of which a current state of charge of the energy storage (18) can be detected, and wherein the control unit (24) is configured to control the switching element (22) in dependence on the state of charge that is detected by the state-of-charge detection module (28), and
wherein the control unit (24) is configured to trigger the switching element (22) if a detected state of charge is below a state-of-charge threshold value.

2. Magnetic field sensor device (10;10') according to claim 1, wherein the control unit (24) is provided with a delay module (26) which can be triggered by a voltage pulse in the sensor element (14;14') of the coil arrangement (13;13') and which is configured to provide a trigger signal after a predetermined delay time.

3. Magnetic field sensor device (10;10') according to claim 2, wherein the control unit (24) is configured to trigger a state-of-charge detection by the state-of-charge detection module (28) in response to the trigger signal of the delay module (26).

4. Magnetic field sensor device (10') according to one of the preceding claims, wherein the coil arrangement (13') is provided with a single coil (32) which constitutes both the sensor element (14') and the feedback element (16').

5. Magnetic field sensor device (10;10') according to one of the preceding claims, wherein the energy storage (18) is a capacitor.

6. Magnetic field sensor device (10;10') according to one of the preceding claims, wherein the switching element (22) is a semiconductor switch.

## Revendications

1. Appareil de détection de champ magnétique (10;10') avec
- au moins deux fils d'impulsion (12a-c),
- un ensemble de bobines (13 ; 13') qui entoure radialement les au moins deux fils d'impulsion (12a-c), l'ensemble de bobines (13 ; 13') constitue
- un élément de détection (14 ; 14') et
- un élément de rétroaction (16 ; 16') par lequel un champ magnétique auxiliaire peut être généré,
- un accumulateur d'énergie (18) qui est connecté électriquement à l'ensemble de bobines (13 ; 13'), et
- un élément de commutation (22) qui est connecté électriquement à l'accumulateur d'énergie (18) et à l'élément de rétroaction (16 ; 16'),
**caractérisé en ce que**
une unité de commande (24) est prévue pour commander électriquement l'élément de commutation (22), l'unité de commande (24) comprenant un module de détection de l'état de charge (28) par lequel un état de charge actuel de l'accumulateur d'énergie (18) peut être détecté, et l'unité de commande (24) étant conçue pour commander l'élément de commutation (22) en fonction de l'état de charge détecté par le module de détection de l'état de charge (28), et
l'unité de commande (24) étant conçue pour commander l'élément de commutation (22) lorsque l'état de charge détecté est inférieur à une valeur seuil d'état de charge.

2. Appareil de détection de champ magnétique (10 ; 10') selon la revendication 1, dans lequel l'unité de commande (24) comprend un module de temporisation (26) qui peut être commandé par une impulsion de tension dans l'élément de détection (14 ; 14') de l'ensemble de bobines (13 ; 13'), et qui est conçu pour fournir un signal de déclenchement après un temps de temporisation prédéterminé.

3. Appareil de détection de champ magnétique (10 ; 10') selon la revendication 2, dans lequel l'unité de commande (24) est conçue pour déclencher une détection de l'état de charge par le module de détection de l'état de charge (28) en réponse au signal de déclenchement du module de temporisation (26).

4. Appareil de détection de champ magnétique (10') selon l'une des revendications précédentes, dans lequel l'ensemble de bobines (13') comprend une seule bobine (32) qui forme à la fois l'élément de détection (14') et l'élément de rétroaction (16').

5. Appareil de détection de champ magnétique (10 ; 10') selon l'une des revendications précédentes, dans lequel l'accumulateur d'énergie (18) est un condensateur.

6. Appareil de détection de champ magnétique (10;10') selon l'une des revendications précédentes, dans lequel l'élément de commutation (22) est un commutateur à semi-conducteur.
